# EUROPEAN PATENT APPLICATION

(11) **EP 1 235 108 A1**
(43) Date of publication of application: **28.08.2002**
(21) Application number: 01104284.3
(22) Date of filing: 22.02.2001
(51) Int. Cl.: G03F 7/09

(54) **Antireflective coating material and semiconductor product with an ARC layer**

(71) Applicant: Infineon Technologies SC300 GmbH & Co. KG, 01099 Dresden (DE)
(72) Inventor: Ganz, Dietmar, 01099 Dresden (DE); Hornig, Steffen, 01454 Radeberg (DE)
(74) Representative: Fischer, Volker, Dipl.-Ing.

(57) **Abstract**

The invention refers to an anti-reflective coating (ARC) layer (2) covering a semiconductor substrate. According to the invention, the ARC layer is made of a matrix substance (3) and of nanocrystalline particles (4) of another material than the matrix substance, the size of the nanocrystalline particles being chosen appropriate for light absorption via the quantum size effect. By the invention, a new kind of ARC layer, in particular absorbing ARC layer, is proposed.

## Description

The invention refers to an antireflective coating material for coating semiconductor products and to a semiconductor product comprising a substrate and an anti-reflective coating (ARC) layer covering the substrate.

In the production of semiconductor products like integrated circuits, wafers are subjected to a lot of process steps like etching, doping and deposition, for instance. Lateral structures of integrated circuits are created by lithography, the semiconductor products being exposed to UV light through a mask pattern. A resist layer on top of the semiconductor product is then etched, thereby either exposed areas or non-exposed areas of the resist layer being removed.

Due to the little depth of the resist layer and the different refractive indexes of the resist layer and the underlying substrate, reflections of exposure light and interferences in the resist layer occur. As a consequence, lateral structures created by lithography tend to deviate from their predefined dimensions.

Diminution of these deviations is achieved by first forming an anti-reflective coating layer, an ARC layer, before forming the resist layer. There are known ARC layers extinguishing reflections by destructive interference of light reflected at the upper and the lower surface of the ARC layer. Other ARC layers reduce reflection by absorption of incoming light.

In another field of the art there are known nanocrystalline particles with particle sizes less than 100 nanometers. They are used for surfaces easy to clean - these surfaces preferably containing fluorine - or for the production of anti-scratch coatings.

It is the object of the present invention to provide a new kind of anti-reflective coating material for coating semiconductor products and a semiconductor product comprising the ARC layer, particularly an ARC layer of improved properties compared to prior art.

This object is achieved by an anti-reflective coating material which is made of a matrix substance and of nanocrystalline particles of another material than the matrix substance, the size of the nanocrystalline particles being chosen appropriate for light absorption via the quantum size effect. According to the invention, light absorption in the ARC layer is achieved by the presence of nanocrystalline particles having a size appropriate for showing the quantum size effect. According to this effect, energy levels within the band gap of the ambient material, that is the matrix substance, are created. Electrons at both sides of the band gap may occupy these additional energy levels, thereby absorbing photons of the exposure light. Hence, a new kind of ARC layer working primarily by absorption arises. Furthermore, as nanocrystalline particles are too small to cause wave reflections, disturbing reflected beams arising from the ARC layer material are suppressed.

With respect to a semiconductor product the product comprises a substrate having a surface and the anti-reflective coating layer arranged on said surface.

Preferably, the size of the nanocrystalline particles is less than 100 nanometers in diameter on average. In particular, average particle sizes of less than a quarter of the wavelength of 284, 193, 157 or 127 nm of UV exposure light are preferred.

According to a preferred embodiment, the matrix substance and the material and the concentration of the particles are chosen corresponding to a predefined refractive index of the ARC layer. These parameters are chosen such that a refractive index granting maximum light entrance into the ARC layer is achieved. Hence, maximum absorption within the ARC layer by means of the nanochrystalline particles is granted.

According to another embodiment of the invention, the material of the particles is chosen corresponding to a predefined wavelength absorbed via the quantum size effect. Depending on the band structure including the band gaps of the matrix substance and the wavelength to be absorbed, the material of the nanocrystalline particles is chosen such that additional energy levels within the band gaps with predefined distance to the valence band or the conduction band are created, the predefined distance corresponding to the wavelength to be absorbed. Preferably, this wavelength is in the UV range.

According to another embodiment, the material and the concentration of the particles are choosing corresponding to a predefined degree of absorption. The degree of absorption may depend on the thickness of the ARC layer and, of course, on the wavelength to be absorbed.

According to another embodiment, the matrix substance and the size and the concentration of the particles are chosen corresponding to a predefined viscosity. An ARC layer is formed by coating a semiconductor product, especially a semiconductor wafer or flat panel, with an ARC layer precursor substance. The ARC layer precursor substance consists of the compounds of the ARC layer as well as the solvent allowing to spin on the ARC layer precursor substance onto a rotating semiconductor product. The amount of solvent in the ARC layer is adjusting its viscosity. When material is spun on, the temperature of the material itself is adjusted in order to optimise the spin process, the uniformity of the final layer on the substrate and the material consumption. The adjusted temperature is controlled during the whole spin process in order to guarantee the reliability of the procedure. The spin process is finished when the layer on the substrate has reached a stable condition in terms of drying. Right after the spin process at least one or more heating processes are applied in order to finalise the process of film creation. However, according to this embodiment, further the matrix substance and the size and the concentration of the particles are adjusted in addition with view to a predefined viscosity.

According to another embodiment, the matrix substance and the material and the concentration of the particles are chosen corresponding to a predefined etch resistance. When a semiconductor product comprising an ARC layer and a resist layer above the ARC layer is etched, etching is proceeded in order to pattern the substrate of the ARC layer in the same way as the pattern mask itself. Precise shaping of three-dimensional structures requires a high etch resistance of the etching mask, that is the resist, and/or of the ARC layer. By carefully choosing the composition of the ARC layer, even this parameter may be controlled.

Preferably, the matrix substance is an organic resin or a silicate. Alternatively, an oxide such as silicon oxide or titanium oxide is preferred.

As to the material of the particles, preferably a metal oxide, a metal sulphide or a perovscite material is chosen. In particular, tin oxide, titanium oxide or cadmium sulphide are preferred. However, there is a lot of other substances with individual band structures leading to appropriate energy levels within the band gap of the matrix substance. Especially oxides and oxide mixtures of metals like Mg, Ca, Ba, Sr, Al, Ga, In, Si, Ge, Ti, Sn, Pb, Sb, Be, Te, Zr, Hf, Nb, Ta, Cr, Mo, W, Mn, Fe, Ru, Co, Rh, Ni, Pd, Zn, Cd, La and of rare earth metals may be taken into account.

Preferably, the ARC layer contains between 3 and 70 % per volume of nanocrystalline particles. The broad range of composition even with respect to the matrix to particle ratio contributes to a most flexible adjustment of the aforementioned parameters.

According to an advanced embodiment of the invention, the ARC layer contains nanocrystalline particles of at least two different materials. Thereby, different ranges of wavelength may be absorbed. By providing different kinds of particles, a predefined absorption profile may be shaped. Furthermore, fine adjustment of absorption profile may be achieved by choosing particles of a predefined average size.

According to the predominant application of ARC layers in lithographic patterning, preferably the semiconductor product comprises a cover layer on top of the ARC layer. Preferably, the cover layer is a resist layer, the resist preferably being made of an organic material.

With view to the intermediate surface between the resist layer and the ARC layer, the refractive index of the ARC layer preferably is differing from the refractive index of the resist layer by less than 15 %.

Thereby light reflection on top of the ARC layer is reduced. Hence, most part of incoming light is entering the ARC layer and is being absorbed by the nanocrystalline articles.

Herein below the invention is described with reference to the accompanying figures.

Figure 1 illustrates a semiconductor product according to prior art.

Figure 2 illustrates a semiconductor product according to the present invention.

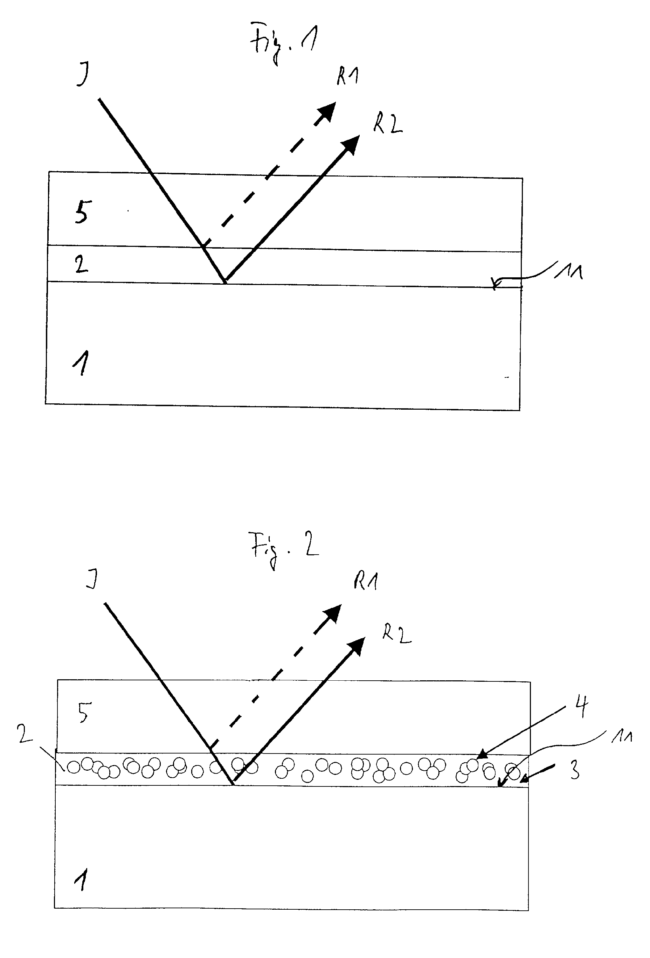

In figure 1, an incoming light beam I entering the resist layer 5 is partially reflected at the intermediate surface between the resist layer and the ARC layer 2 below, the reflected beam being denoted as R1. The remaining intensity enters the ARC layer and is reflected at the intermediate surface 11 between the ARC layer 2 and the substrate 1, the resulting reflected beam R2 extinguishing the other beam R1 at least in part via destructive interference.

In case of absorbing ARC layers, the refractive index of the ARC layer 2 is adjusted to be similar to the refractive index of the resist layer 5, thereby producing maximum transmission of beam I into layer 2 and absorbing beam I within the ARC layer material. The present invention predominantly refers to the absorbing kind of ARC layers, however, it applies also to destructive interference ARC layers as with view to the three refractive indexes of resist 5, ARC layer 2 and substrate 1 an intensity variation of reflected beam R2 may be useful. The reflected beam R1 is drawn in dashed lines as its intensity is rather low in case of absorbing ARC layers.

Whereas prior art ARC layer material is homogeneous, according to the present invention illustrated in figure 2, the ARC layer 2 comprises a matrix substance 3 embedding nanocrystalline particles 4 causing absorption of incoming light via the quantum size effect.

By exploiting this mechanism in ARC layer 2, the reflected beam 2 is absorbed. The absorption profile can be shaped by providing different kinds or sizes of nanocrystalline particles, these and other composition parameters allowing an adjustment of further physical properties of the ARC layer itself.

The production of the ARC layer material compounds is produced in well-known manner. Nanocrystalline particles are extracted by chemical hydrolysis condensation; the matrix substance is produced by a sole gel process. According to the invention, the matrix substance and the nanocrystalline particles are mixed and other chemical substances like solvents or surface-active agents for better adhesion to the substrate are added. The ARC layer material composition is then spun onto the substrate and then heated up to a temperature not above 200° C in order not to crack polymer hydrocarbon chains of the matrix substance. During the heating, a certain amount of the solvent is removed and matrix substance molecules are interconnected with one another, thereby forming a network safely embedding the nanocrystalline particles.

It will be familiar to a skilled person to chose kinds and quantities of the matrix substance and of the nanocrystalline particles in order to appropriately tune physical properties like refractive index, absorption profile, viscosity and etch resistance of the ARC layer.

## Claims

1. Anti-reflective coating (ARC) material (2) for coating a semiconductor product,
**characterised in that**
the anti-reflective coating material is made of a matrix substance (3) and of nanocrystalline particles (4) of another material than the matrix substance, and that the size of the nanochrystalline particles is chosen appropriate for light absorption via the quantum size effect.

2. Anti-reflective coating material according to claim 1,
**characterised in that**
the size of the nanocrystalline particles is less than 100 manometers in diameter on average.

3. Anti-reflective coating material according to claim 2,
**characterised in that**
the size of the nanocrystalline particles is less than a quarter of the wavelength of 248, 193, 157 or 127 nm of UV exposure light.

4. Anti-reflective coating material according to one of claims 1 to 3,
**characterised in that**
the material of the particles is chosen corresponding to a predefined wavelength absorbed via the quantum size effect.

5. Anti-reflective coating material according to claim 4,
**characterised in that**
the predefined wavelength is in the UV range.

6. Anti-reflective coating material according to one of claims 1 to 5,
**characterised in that**
the material and the concentration of the particles are chosen corresponding to a predefined degree of absorption.

7. Anti-reflective coating material according to one of claims 1 to 6,
**characterised in that**
the matrix substance and the size and the concentration of the particles are chosen corresponding to a predefined viscosity.

8. Anti-reflective coating material according to one of claims 1 to 7,
**characterised in that**
the matrix substance and the material and the concentration of the particles are chosen corresponding to a predefined etch resistance of a dry etch process for etching semiconductor substrates.

9. Anti-reflective coating material according to one of claims 1 to 8,
**characterised in that**
the matrix substance is an organic resin or a silicate.

10. Anti-reflective coating material according to one of claims 1 to 8,
**characterised in that**
the matrix substance is an oxide, preferably a silicon oxide or a titanium oxide.

11. Anti-reflective coating material according to one of claims 1 to 10,
**characterised in that**
the material of the particles is a metal oxide, a metal sulphide or a perovscite material.

12. Anti-reflective coating material according to one of claims 1 to 11,
**characterised in that**
the material of the particles contains tin oxide, titanium oxide or cadmium sulphide.

13. Anti-reflective coating material according to one of claims 1 to 12,
**characterised in that**
the ARC layer contains between 3 and 70 % per volume of nanocrystalline particles.

14. Anti-reflective coating material according to one of claims 1 to 13,
**characterised in that**
the ARC layer contains nanocrytalline particles of at least two different materials.

15. Semiconductor product comprising a substrate (1) having a surface (11) and an anti-reflective coating (ARC) layer (2) arranged on said surface (11) comprising the anti-reflective coating material according to one of claims 1 to 14.

16. Semiconductor product according to claim 15,
**characterised in that**
the matrix substance and the material and the concentration of the particles are chosen corresponding to a predefined refractive index of the ARC layer.

17. Semiconductor product according to one of claims 15 or 16,
**characterised in that**
the semiconductor product comprises a cover layer (5) on top of the ARC layer.

18. Semiconductor product according to claim 17,
**characterised in that**
the cover layer is a resist layer (5).

19. Semiconductor product according to one of claims 15 to 18,
**characterised in that**
the refractive index of the ARC layer is differing from the refractive index of the resist layer by less than 15 %.
